# EUROPEAN PATENT APPLICATION

(11) **EP 2 441 811 A2**
(43) Date of publication of application: **18.04.2012**
(21) Application number: 11008205.4
(22) Date of filing: 11.10.2011
(51) Int. Cl.: C09J 5/00, H01L 21/67, H01L 21/683

(54) **Double-faced adhesive tape joining method and double-faced adhesive tape joining apparatus**

(30) Priority: 12.10.2010 JP 2010229534
(71) Applicant: Nitto Denko Corporation, Osaka 567-8680 (JP)
(72) Inventor: Yamamoto, Masayuki, Ibaraki-shi Osaka 567-8680 (JP)
(74) Representative: Werner, Richard

(57) **Abstract**

An original master tape having a long carrier tape and a long double-faced adhesive tape joined thereto is guided to a knife edge to be folded back. The double-faced adhesive tape is half-cut on the carrier tape in front of the knife edge with a Thomson blade having a corresponding shape to a substrate. The original master tape is folded back at the knife edge. Accordingly, a piece of the double-faced adhesive tape cut into the substrate shape is separated from the carrier tape to be joined to the substrate traveling relatively at a speed synchronized to a separation speed.

## Description

### BACKGROUND OF THE INVENTION

(1) Field of the Invention

This invention relates to a method and apparatus for joining a double-faced adhesive tape to a substrate such as a semiconductor wafer.

(2) Description of the Related Art

In recent years, a semiconductor wafer (hereinafter, appropriately referred to as a "wafer") tends to be thinned. Accordingly, in order to compensate for rigidity of the wafer under processing such as a back grinding process, a support substrate, such as a glass plate and a metal plate, that is formed into the same shape as the wafer is joined to a surface of the wafer via a double-faced adhesive tape.

For joining the support substrate having the same shape as the wafer to the surface of the wafer via the double-faced adhesive tape, the double-faced adhesive tape is firstly joined to the surface of the wafer. Thereafter, the support substrate is joined to the wafer via the double-faced adhesive tape having the wafer joined thereto. For instance, such as apparatus applying adhesive film joining apparatus is adopted as apparatus for joining the double-faced adhesive tape to the surface of the wafer. See Japanese Patent Publication No. H07-195527.

Specifically, pieces of the double-faced adhesive tape pre-cut in advance in a wafer shape are joined and supported onto a long carrier tape at given intervals to form an original master tape for supply of the double-faced adhesive tape. The original master tape is feed out from an original master roll on which the tape is wound in a roll form, and is guided to a knife edge. Then, the original master tape travels while being folded back with the knife edge. At this time, the piece of the double-faced adhesive tape separates from the carrier tape at the knife edge. The separated piece of the double-faced adhesive tape is to be joined to the surface of the wafer that moves at a speed synchronized to a separation speed.

The pieces of the double-faced adhesive tape on the original master roll used for the conventional apparatus are intermittently joined and supported onto the carrier tape to be wounded in a roll form. Consequently, the original master tape is to be wound in a roll form having different thicknesses between a portion with the piece of the double-faced adhesive tape and a portion with no piece of the double-faced adhesive tape. As a result, non-uniform winding of the tape may occur during a transportation process when the tape is not sufficiently wound up.

Moreover, when the tape is not sufficiently wound up, the tape deforms into a cone shape when set in the apparatus. Accordingly, the tape serpentines during transportation of the original master tape. Consequently, there arises a problem as under. That is, the substrate and the piece of the double-faced adhesive tape deviate from each other in its joining position, which leads to joining of the piece of the double-faced adhesive tape to the substrate with lower accuracy.

Moreover, another problem may arise as under. That is, when the tape is wound up too tightly, a step between an edge of the piece of the double-faced adhesive tape and the carrier tape may be pressed against the laminated carrier tape and the piece of the double-faced adhesive tape through winding, which may occurrence of impressions therein.

Particularly, the double-faced adhesive tape has a thick portion where a separator is provided on an adhesive surface to be joined to the carrier tape and on an opposite adhesive surface (for joining of the support substrate.) Consequently, the original master tape has a difference in thickness between a portion with the piece of the double-faced adhesive tape and a portion with no double-faced adhesive tape. Thus, the foregoing problem will notably occur in rolling up the original master tape.

### SUMMARY OF THE INVENTION

This invention has been made regarded to the state of the art noted above, and its primary object is to provide a method and apparatus for efficiently joining to a substrate a double-faced adhesive tape pre-cut into a shape of the substrate.

This invention discloses a method of joining a double-faced adhesive tape to a substrate. The method includes the steps of feeding out an original master tape from an original master roll, the original master tape having a long carrier tape and the long double-faced adhesive tape joined thereto; half-cutting the double-faced adhesive tape in advance to the carrier tape with a cutting member having a corresponding shape to the substrate; separating the double-faced adhesive tape cut out into a substrate shape from the carrier tape; and joining the double-faced adhesive tape to the substrate through traveling and folding back the carrier tape having a piece of the double-faced adhesive tape in the substrate shape applied thereto with a knife edge to separate a piece of the double-faced adhesive tape in the substrate shape from the carrier tape, and joining a separated piece of the double-faced adhesive tape to the substrate relatively moving at a speed synchronized to a separation speed.

According to this method, the original master tape having a uniform thickness is rolled. Consequently, a pressure due to rolling up may be applied uniformly to a surface of the tape. Thus, when the original master tape is rolled up insufficiently as in the case of the original master tape provided with pre-cut pieces of the double-faced adhesive tape on the carrier tape, reduction in accuracy of joining the tape and serpentine following turbulent winding in transporting the tape may be suppressed as compared to the conventional method.

Moreover, even when the original master tape is rolled up tightly, no impression by the edge of the piece of the double-faced adhesive tape cut into the substrate shape is applied on the laminated pieces of the double-faced adhesive tape.

Consequently, in the foregoing method, when the substrate is a semiconductor wafer and back grinding is performed while the substrate is joined to the support substrate via the piece of the double-faced adhesive tape, variation in thickness of the wafer to be ground may be suppressed that occurs due to the steps by impressions.

Moreover, the double-faced adhesive tape is fed out from the original master roll, and cut into the substrate shape to be guided to the knife edge. Accordingly, the cut double-faced adhesive tape having the separator laminated thereto may travel to the knife edge without largely bending of the original master tape. In other words, the double-faced adhesive tape may be guided to the knife edge under a proper joining condition with no inadvertent separation and floating of the separator from the piece of the double-faced adhesive tape. As a result, the piece of the double-faced adhesive tape with the separator may be separated with the knife edge and joined to the substrate while being properly pressed with a joining roller.

Moreover, in the foregoing method, the cutting member is preferably a Thomson blade having an annular cutting edge for pressing against the double-faced adhesive tape on the carrier tape to cut the double-faced adhesive tape into the substrate shape.

When the Thomson blade is adopted for substrates in various shapes, the piece of the double-faced adhesive tape having a corresponding shape thereto may be half-cut accurately within an extremely short period of time. Moreover, two or more types of Thomson blades each corresponding to the substrate shape are prepared in advance, and a cutting blade is replaced in accordance with a substrate to be processed. Accordingly, the piece of the double-faced adhesive tape corresponding to various substrates may be formed through cutting.

This invention also adopts the configuration as stated below to accomplish such object. That is, this invention discloses double-faced adhesive tape joining apparatus for joining a double-faced adhesive tape to a substrate. The apparatus includes a tape supply unit for supplying from an original master roll an original master tape having the long double-faced adhesive tape laminated to a long carrier tape joined therefo; a tape traveling guidance mechanism for traveling the original master tape fed out from the tape supply unit along a given tape transportation path and guiding the original master tape to a knife edge; a tape pre-cut mechanism for half-cutting the double-faced adhesive tape to the carrier tape into a substrate shape on the tape transportation path in front of the knife edge to form a piece of the double-faced adhesive tape; a tape separation mechanism for separating the double-faced adhesive tape cut out into the substrate shape from the carrier tape; a joining table for holding the substrate; a table driving mechanism for relatively moving the joining table relative to the knife edge at a speed synchronized to a tape traveling speed; a tape joining mechanism provided with a joining roller for pressing against the substrate on the joining table the piece of the double-faced adhesive tape in the substrate shape that is separated from the carrier tape through folding back and traveling the original master tape with the knife edge; and a carrier tape collecting section for collecting the carrier tape from which the piece of the double-faced adhesive tape is separated.

According to this configuration, the original master tape fed out from the tape supply unit travels along a given tape transportation path and is guided to the knife edge. The tape pre-cut mechanism half-cuts the double-faced adhesive tape on the carrier tape into a shape corresponding to the substrate shape in the course of tape transportation. The tape separation mechanism separates from the carrier tape an unnecessary portion of the double-faced adhesive tape having the pieces of the double-faced adhesive tape cut out therefrom, and collects the portion. Thereafter, the original master tape travels and is folded back at the knife edge. Here, the piece of the double-face adhesive tape cut into the substrate shape is separated from the carrier tape, and is pressed against the substrate on the joining table for joining with the joining roller provided in the tape joining mechanism. The carrier tape from which the piece of the double-faced adhesive tape is separated at the knife edge is folded back, and thereafter travels on a given transportation path for collection. Accordingly, the apparatus may suitably perform the foregoing method.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

Figure 1 is a plan view of double-faced adhesive tape joining apparatus.

Figure 2 is a side view showing main components of the apparatus.

Figure 3 is a perspective view showing main components of the apparatus.

Figures 4A to 4C are schematic side views each showing operations of a tape pre-cut mechanism.

Figure 5 is a plan view of a tape joining section.

Figure 6 is a plan view of a joining table.

Figure 7 is a side view of the joining table.

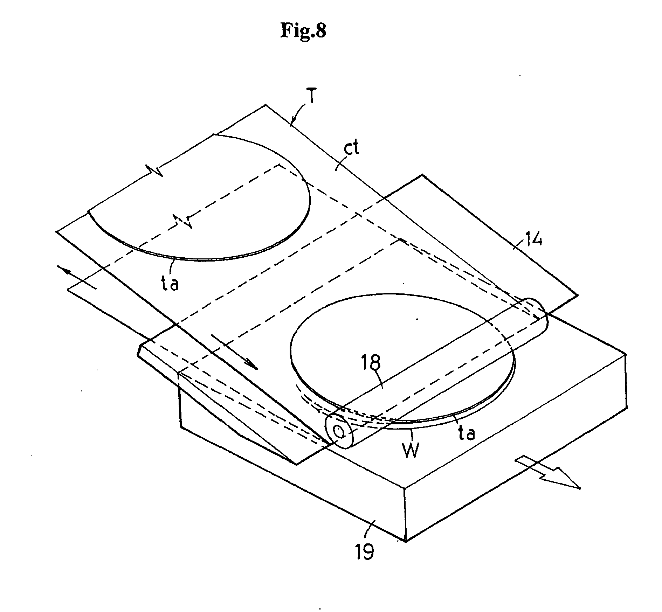

Figure 8 is a perspective view of the tape joining section.

Figures 9A and 9B are schematic side views each showing operations of joining a double-faced adhesive tape.

Figure 10 is a side view of a tape separating section.

Figures 11A and 11B are schematic side views each showing operations of separating a separator.

Figure 12 is a schematic side view showing operations of separating a poorly joined double-faced adhesive tape.

### DESCRIPTION OF THE PREFERRED EMBODIMENTS

One embodiment of this invention is now to be described below with reference to the drawings.

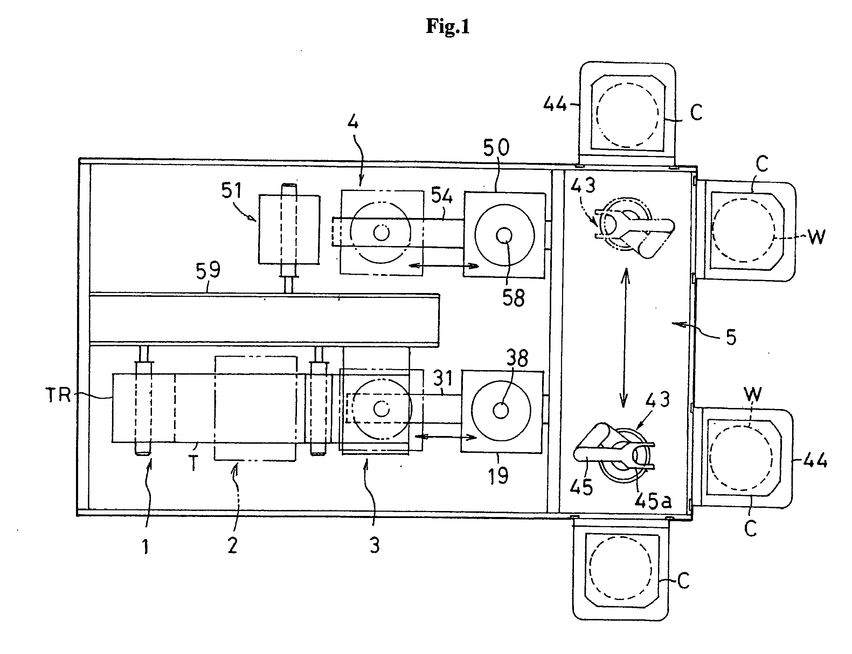

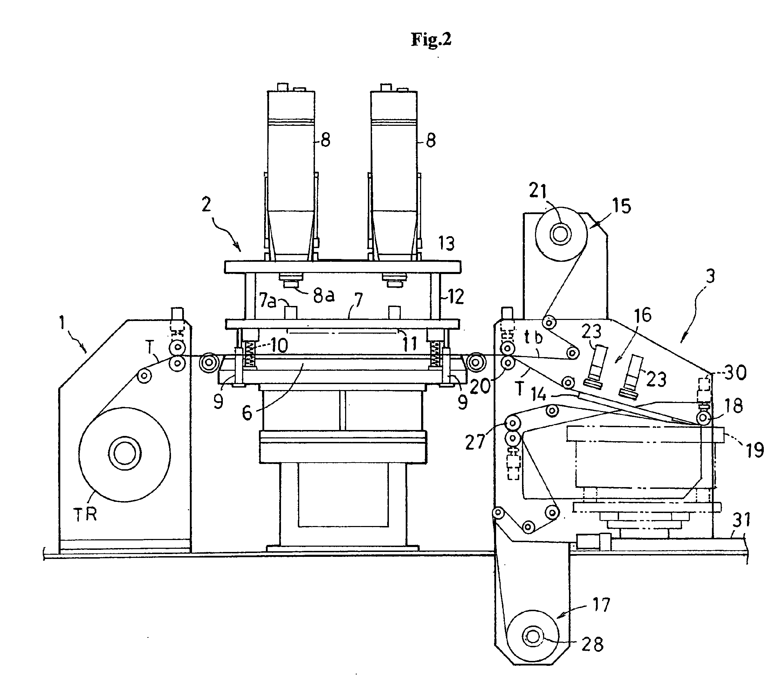

Figure 1 is a schematic plan view of double-faced adhesive tape joining apparatus according to this invention. Figure 2 is a side view of main components thereof.

The double-faced adhesive tape joining apparatus joins a double-faced adhesive tape for joining a support substrate for reinforcement to a surface of a semiconductor wafer W (hereinafter, simply referred to as a "wafer W"), which is one example of a substrate. A tape supply unit 1, a tape pre-cut mechanism 2, and a tape joining section 3 are placed in series in the longitudinal direction (in the left-right direction in Figure 1) of the apparatus. A tape separating section 4 is placed on the lateral side (the upper side in Figure 1) of the tape joining section 3. A long substrate transportation section 5 is placed in the left-right direction (a vertical direction in Figure 1) as to face toward the tape joining section 3 and the tape separating section 4. The apparatus has such basic configuration as above. In addition, a tape traveling guidance mechanism, such as a feed roller and a guide roller, is configured from the tape supply unit 1 to the tape joining section 3.

As shown in Figure 2, the tape supply unit 1 feeds out an original master tape T from an original master roll TR in a roll form. The original master tape T is guided on a given tape path via the tape pre-cut mechanism 2 to the tape joining section 3.

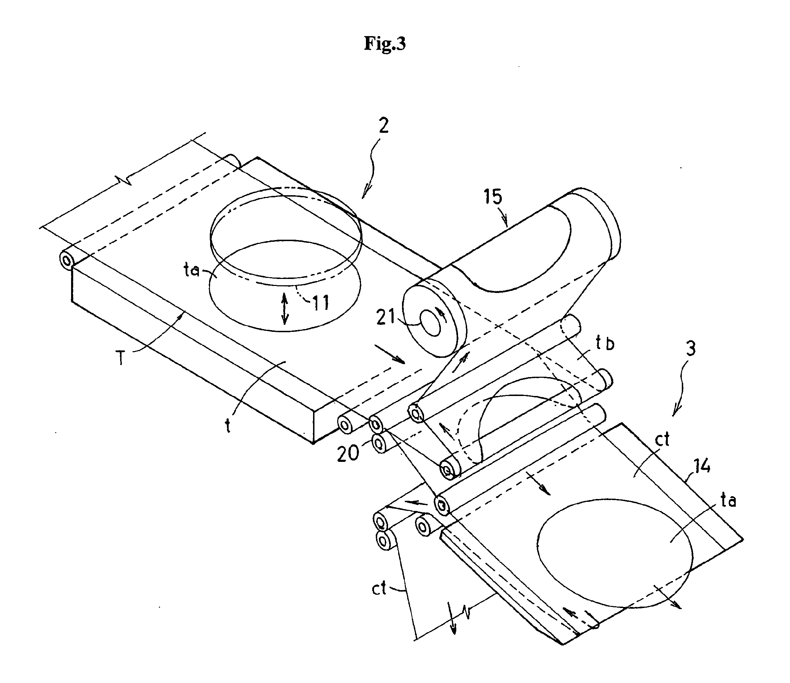

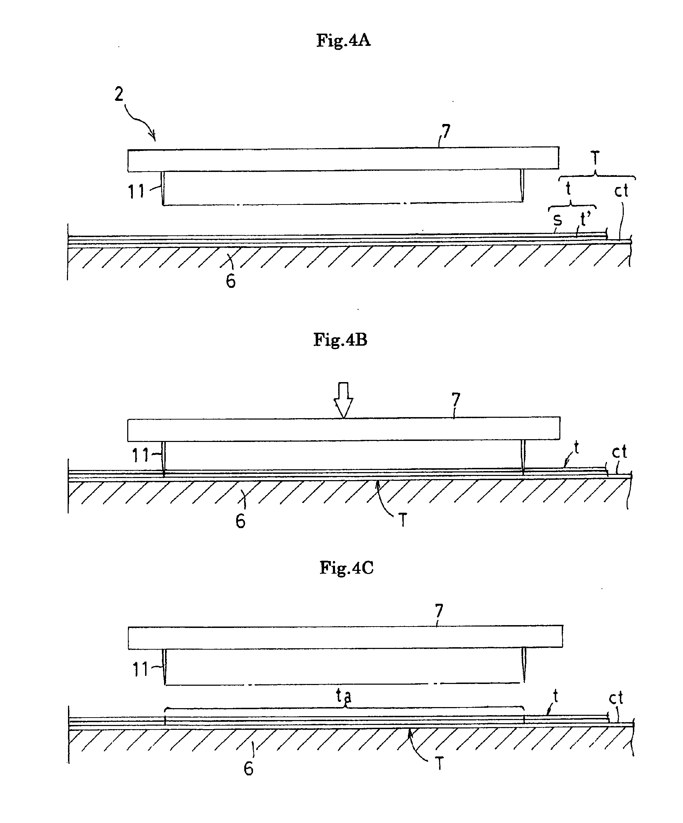

As shown in Figures 3 and 4, the original master tape T is formed of a carrier tape ct having a larger width than a diameter of a wafer W and a double-faced adhesive tape t having the same width as the carrier tape ct that are joined to each other. The double-faced adhesive tape t itself is formed through joining a separator s on one adhesive surface directed upward of a double-faced adhesive tape body t' having upper and lower adhesive surfaces.

As shown in Figure 2, the tape pre-cut mechanism 2 includes a tape supporting table 6, a blade holder 7, and a driving cylinder 8. The tape supporting table 6 is fixedly provided as to receive the original master tape T horizontally that is transported from the original master roll TR. The blade holder 7 is arranged as to move upward and downward above the tape supporting table 6. The driving cylinder 8 is provided above the blade holder 7 that allows the blade holder to move upward and downward.

The blade holder 7 is supported via a slide guide shaft 9 as to move upward and downward while maintaining a horizontal attitude. Moreover, the blade holder 7 is biased upward in a given standby position through a return spring 10. The blade holder 7 has an annular Thomson blade 11 on a lower surface thereof with a corresponding contour to the wafer to be processed.

The driving cylinder 8 is attached vertically on a stand 13 fixed via a strut 12 on the tape supporting table 6. Moreover, a plunger 8a projects downward to contact a shank 7a projecting from an upper surface of the blade holder 7, whereby a force against upward return bias is applied to the blade holder 7 to move the driving cylinder 8 downward. At this time, the Thomson blade 11 is pressed against the original master tape T on the tape supporting table 6. In this embodiment, four driving cylinders 8 are attached along a given circumference at equal intervals on the stand 13.

As shown in Figures 2 and 3, the tape joining section3 includes a wide knife edge 14, an unnecessary adhesive tape collecting section 15, a tape position monitoring mechanism 16, a carrier tape collecting section 17, a joining roller 18, and a joining table 19. The wide knife edge 14 folds back and guides the half-cut original master tape T transported from the tape pre-cut mechanism 2. The unnecessary adhesive tape collecting section 15 separates and winds up and collects a band-shaped double-faced adhesive tape tb that remains around the cut-out pieces ta of the double-faced adhesive tape in front of the knife edge 14. The tape position monitoring mechanism 16 is located above the knife edge 14. The carrier tape collecting section 17 winds up and collects the carrier tapes ct folded back downward with the knife edge 14. The joining roller 18 faces from an upper side toward a tip of the knife edge 14. The joining table 19 is arranged below the knife edge 14 as to reciprocate horizontally.

The unnecessary adhesive tape collecting section 15 separates from the carrier tape ct the unnecessary double-faced adhesive tape tb remaining around the cut piece ta of the double-faced adhesive tape in the wafer shape immediately after a tape transport roller 20, and winds up the unnecessary double-faced adhesive tape tb onto a collection bobbin 21. Accordingly, the original master tape T having the piece ta of the double-faced adhesive tape remaining on the carrier tape ct with the separator is guided to the knife edge 14.

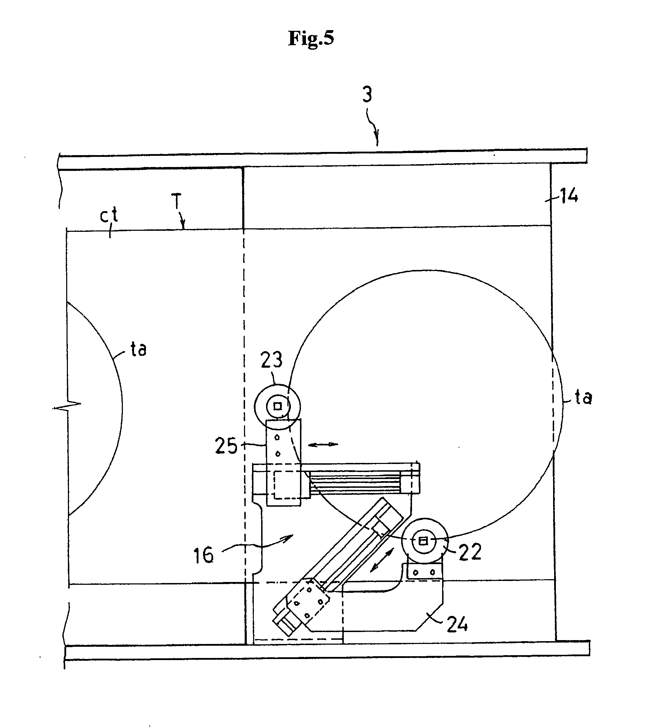

The tape position monitoring mechanism 16 detects one end of the piece ta of the double-faced adhesive tape in a tape width direction (the left-right direction) that is cut out into the wafer shape, and front and rear ends of the piece ta of the double-faced adhesive tape in a tape traveling direction using monitoring cameras 22 and 23, respectively. As shown in Figure 5, the monitoring cameras 22 and 23 are supported on movable brackets 24 and 25, respectively, that move linearly in a screw feed manner. Positional information on a lateral end and front and rear ends of the piece ta of the double-faced adhesive tape may be obtained through determining a movement position where the ends of the piece ta of the double-faced adhesive tape has been detected. Obtained information is sent to a controller.

As shown in Figure 2, the carrier tape collecting section 17 drives to send the carrier tape ct folded back up by the knife edge 14 with a roller 27, and wind it up with a collection bobbin 28.

A driving cylinder 30 moves upward and downward the joining roller 18. Accordingly, the joining roller 18 presses the upper surface of the piece ta of the double-faced adhesive tape with the separator that is separated from the carrier tape ct at the tip end of the knife edge 14 against the upper surface of the wafer W that is suction-held on the joining table 19 and moves horizontally. Here, the joining roller 18 and the driving cylinder 30 constitute the tape joining mechanism in this invention.

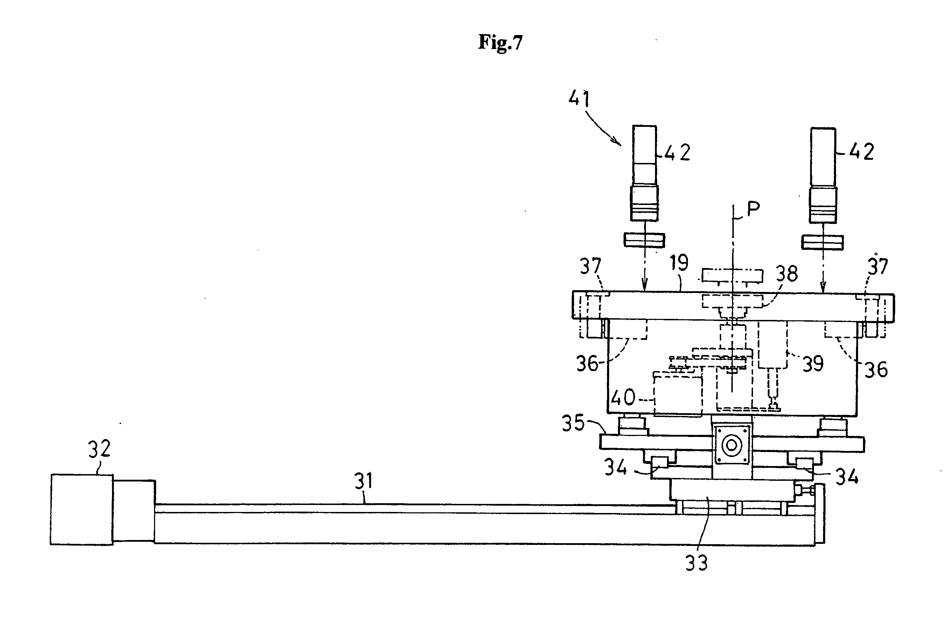

The joining table 19 is movable in the longitudinal and left-right directions. That is, as shown in Figures 2 and 7, a rail 31 is longitudinal horizontally installed as to extend under the knife edge 14. The joining table 19 includes a front-to rear direction movable board 33 that moves in a screw feed manner along the rail 31 via a motor 32. Rails 34 are fixed in parallel on both sides of the front-to rear movable board 33. A left-to-right movable board 35 is provided that moves in a screw manner along the rails 34 via a motor, not shown. Moreover, the left-to-right movable board 35 includes a joining table 19 thereon.

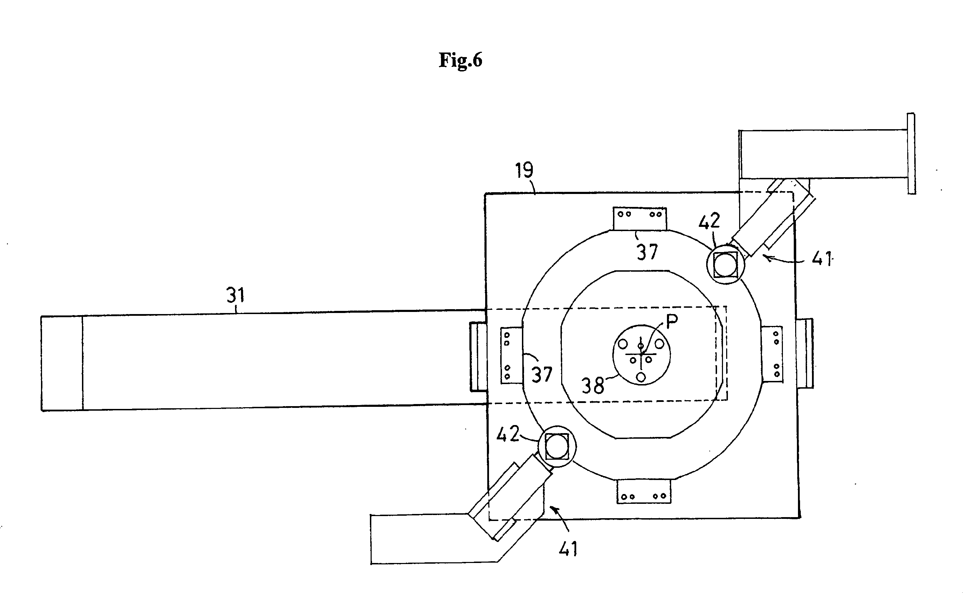

As shown in Figure 6, positioning members 37 are arranged at four points along four sides of the joining table 19 as to move in and out toward the center of the table via a cylinder 36. The positioning members 37 press an outer periphery of the wafer W placed on the joining table 19 at four points toward the center of the table, thereby positioning the wafer W on the center of the table.

The joining table 19 includes at the center thereof a suction pad 38 having an upper surface formed as a vacuum-suction surface. As shown in Figure 7, a cylinder 39 drives the suction pad 38. The suction pad 38 is interlocked with a motor 40 via a belt to rotate about a vertical axis P through the center of the joining table 19.

A joining inspection mechanism 41 is positioned above the joining table 19. The joining inspection mechanism 41 has a pair of monitoring cameras 42 for monitoring a diagonal circumference of the wafer W to detect positional deviation of the piece ta of the double-faced adhesive tape relative to the wafer W and finishing condition of a cutting edge of the piece ta of the double-faced adhesive tape (sharpness).

As shown in Figure 1, the substrate transportation section 5 includes a transportation robot 43 movable horizontally. The substrate transportation section 5 includes around thereof two or more cassettes C and support boards 44 for cassette C that are each movable upward and downward. The support board 44 is provided for the cassette C into which wafers W prior to joining of the double-faced adhesive tape t are inserted and housed in a stack manner, and another support board 44 is for the cassette C into which the wafers W subject to joining of the double-faced adhesive tape t are inserted and housed.

The transportation robot 43 includes a robot arm 45 that is bendable horizontally and rotatable in all directions. The robot arm 45 has at a free end thereof a suction section 45a in a U-shape with an upper surface thereof formed as a vacuum-suction surface.

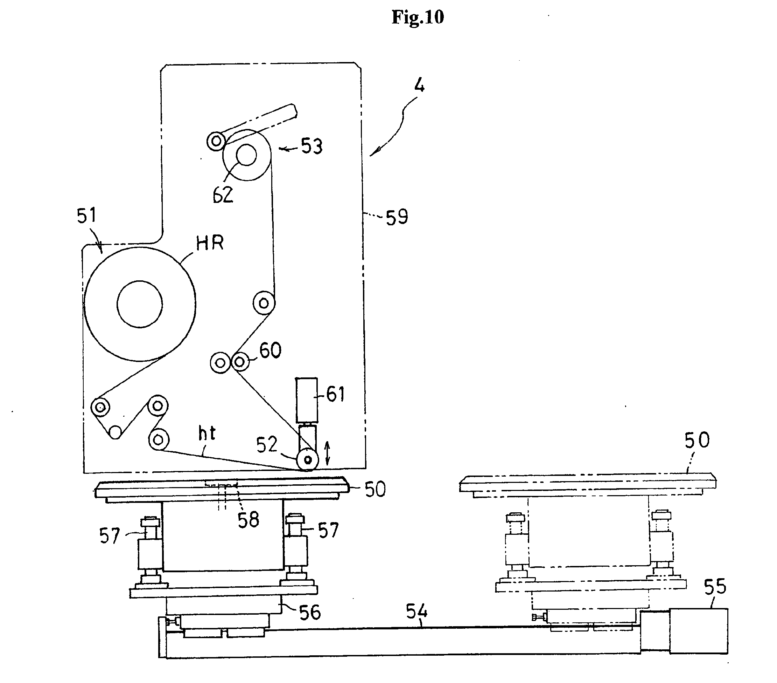

As shown in Figure 10, the tape separation section 4 includes a separation table 50, a separation tape supply unit 51, a separation roller 52, and a separation tape collecting section 53.

The separation table 50 is movable longitudinal horizontally and vertically. Specifically, a movable board 56 is provided that moves via a motor 55 in a screw-feed manner along rails 54 located longitudinal horizontally. The separation table 50 is held on the movable board 56 via a guide shaft 57 as to move vertically. In addition, the suction pad 58 is provided on a center of the separation table 50 as to transport the wafer W.

The separation table 51, the separation roller 52, and the separation tape collection section 53 are provided on a frame plate 59 fixed above a side of a separation table moving path.

The separation tape supply unit 51 feeds out a separation tape ht from an original master roll HR to guide it through the separation roller 52 to a feed roller 60. Here, the separation tape ht is wound up on the separation roller 52 having the adhesive surface thereof being directed downward.

The separation roller 52 is positioned below the frame plate 59 as to face toward the separation table 50. A cylinder 61 moves upward and downward the separation roller 52.

The separation tape collecting section 53 winds up on a collection bobbin 62 the separation tape ht directed upward that is fed out from the feed roller 60, and collects it.

The double-faced adhesive tape joining apparatus according to this invention is configured as above. Description will be given of a series of operations of joining the double-faced adhesive tape to the surface of the wafer using the apparatus with reference to drawings.

In the substrate transportation section 5, the robot arm 45 of the transportation robot 43 is inserted into a given cassette C mounted on the support board 44. The robot arm 45 suction-holds a rear face of one housed wafer W, and pulls out the wafer W having the surface directed upward. The robot arm 45 transports the wafer W above the joining table 19 in front of the tape joining section 3 in a standby state.

The joining table 19 has the suction pad 38 projecting therefrom in a standing state. The robot arm 45 temporally places the transported wafer W to the suction pad 38. The robot arm 45 retracts from the joining table 19. The suction pad 38 moves downward to place the wafer W on the holding table 19.

The wafer W is placed on the joining table 19, and then the positioning members 37 on the four sides each move toward the center of the table to position the wafer W on the center of the table. The vacuum pump, not shown, operates with the wafer W positioned as above to suction-hold the wafer W on the joining table 19. Thereafter, the joining table 19 moves backward to a given position below the tape joining section 3.

In the tape pre-cut mechanism 2 as shown in Figure 4A, the Thomson blade 11 is located above the tape support board 6 in a standby position. Then, the driving cylinder 8 operates to move the blade holder 7 downward due to a force against a bias force of the return spring 10 to press the Thomson blade 11 against the original master tape T stopping on the tape support board 6. Here, as shown in Figure 4, the blade holder 7 has lower limitation on downward movement such that the Thomson blade 11 only cuts the double-faced adhesive tape t with the separator s on the original master tape T and does not entirely cut the carrier tape ct. The Thomson blade 11 cuts the double-faced adhesive tape t, and thereafter returns to its standby position as in Figure 4C. The double-faced adhesive tape t is cut into the wafer shape, and then the original master tape T is fed forward.

Only a unnecessary portion of the double-faced adhesive tape tb having a cut-out hole is separated from the carrier tape ct and collected in the unnecessary adhesive tape collecting section 15. In this case, the piece ta of the double-faced adhesive tape cut out into the wafer shape remains on the carrier tape ct.

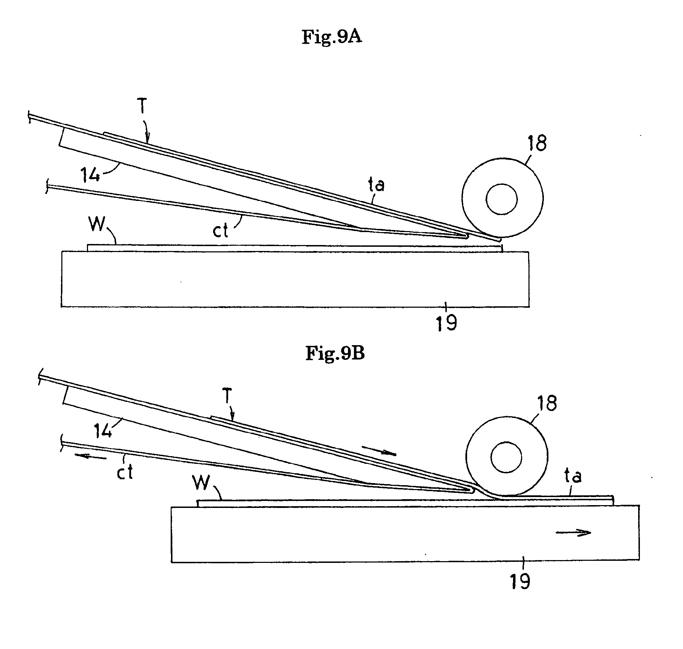

The original master tape T having only the piece ta of the double-faced adhesive tape joined to the carrier tape t travels and is folded back with the knife edge 14. Here, the piece ta of the double-faced adhesive tape is separated from the carrier tape ct that is folded back while traveling. Accordingly, the piece ta of the double-faced adhesive tape travels forward along an upper surface of the knife edge 14. Thereafter, as shown in Figure 9A, a front end of the piece ta of the double-faced adhesive tape moves across the tip end of the knife edge 14. When the front end arrives immediately below the joining roller 18 in the standby position, the tape temporarily stops traveling.

Here, the monitoring cameras 22, 23 detects a front end, side ends, and a rear end of the piece ta of the double-faced adhesive tape, in this order, that is fed to the tape joining section 3 with the carrier tape ct. Specifically, the monitoring camera 23 acquires an image of the front end. The monitoring camera 22 acquires images of the side ends. The monitoring camera 23 acquires an image of the rear end. Positional information is obtained through each of the images, and is sent to a controller.

The controller determines position coordinates of an outer periphery of the wafer W from each portion of the piece ta of the double-faced adhesive tape in each image. Determination is made of deviation in positional direction and amount between the piece ta of the double-faced adhesive tape and the wafer held on the joining table 19 in accordance with each position coordinate of the piece ta of the double-faced adhesive tape. That is, a distance of the piece ta of the double-faced adhesive tape in the transportation direction is calculated from each coordinate of the front and rear ends of the piece ta of the double-faced adhesive tape. A position where the distance is the maximum is determined as a tip. Deviation in positional direction and amount is determined from pattern matching of the position of the tip calculated in advance, the image of the side ends, and a reference image acquired in advance.

The controller controls the joining table 19 as to operate longitudinal horizontally, in the left-right direction, and about the vertical axis P in accordance with calculated deviation in direction and amount of the piece ta of the double-faced adhesive tape, thereby correcting a joining position.

Subsequently, the joining roller 18 moves downward to press the front end of the piece ta of the double-faced adhesive tape projecting forward from the knife edge 14 against a front end surface of the wafer W held on the joining table 19. Thereafter, as shown in Figure 9B, the tape starts traveling again. The joining table 19 moves at a speed synchronized to a forward movement speed of the piece ta of the double-faced adhesive tape that moves forward while being separated from the carrier tape ct. That is, joining roller 18 successively joins the piece ta of the double-faced adhesive tape separated from the carrier tape ct on the surface of the wafer W.

Upon completion of joining the piece ta of the double-faced adhesive tape, the joining table 19 moves to a give standby position and then stops, where the joining inspection mechanism 41 inspects joining condition and cutting condition of the piece ta of the double-faced adhesive tape.

When the above tape joining inspection is completed, the joining table 19 releases suction holding of the wafer W and the suction pad 38 moves upward. The transport robot 43 then transports the wafer W on the suction pad 38 toward to the tape separation section 4, and places the wafer W on the separation table 50 in a forward given standby position.

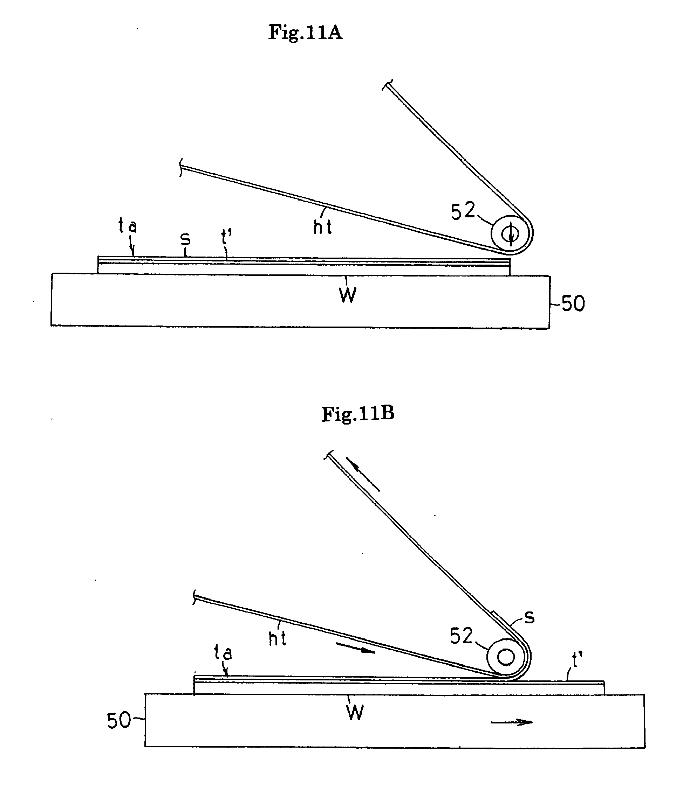

The separation table 50 having the wafer W placed and suction-held thereon once moves backward (to the left in Figure 1.) Thereafter, as shown in Figure 11A, the table stops when the end of the wafer W reaches immediately below the separation roller 52. The separation roller 52 moves downward to press the separator s of the piece ta of the double-faced adhesive tape having an adhesive surface of the separation tape ht joined to the upper surface of the wafer W, the adhesive surface being directed downward. Thereafter, as shown in Figure 11 B, the separation table 50 returns forward, and accordingly, the separation tape ht travels at a speed synchronized to return movement of the separation table 50 for collecting. That is, the separator s joined and held onto the separation tape ht is separated from the adhesive surface of a double-faced adhesive tape body t' in the piece ta of the double-faced adhesive tape directed upward due to return movement of the separation table 50. Accordingly, the separator s is wound up and collected together with the separation tape ht.

Upon completion of separating and removing the separator s from the double-faced adhesive tape body t', the separation roller 52 returns upward and the separation table 50 returns to its original standby position and then stops. Here, when a prior inspection verifies proper joining of the piece ta of the double-faced adhesive tape, the transportation robot 43 transports the wafer W from the separator table 50 to insert and house it into a given cassette C.

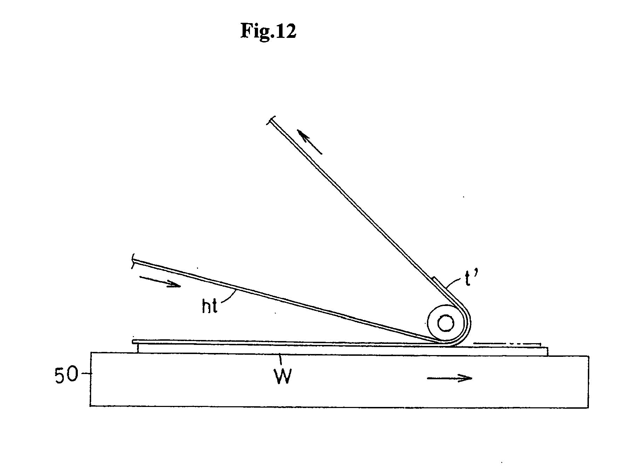

When it is verified that the piece ta of the double-faced adhesive tape placed on the separation table 50 is not joined properly to the wafer W, the same operation as the foregoing separation of the separator s is to be repeated. Specifically, the separation table 50 moves and temporally stops as to position the separation roller immediately below the wafer W. The separation roller 52 moves downward to press the separator s of the piece ta of the double-faced adhesive tape having an adhesive surface of the separation tape ht joined to the upper surface of the wafer W, the adhesive surface being directed downward. Thereafter, as shown in Figure 12, the separation table 50 returns forward, and accordingly, the separation tape ht travels at a speed synchronized to return movement of the separation table 50 for collection. That is, the separation tape ht is joined to the double-faced adhesive tape body t' in the piece ta of the double-faced adhesive tape remaining on the upper surface of the wafer W due to return movement of the separation table 50. The separation tape ht is wound up and collected, whereby the double-faced adhesive tape body t' is separated from the wafer W with the separation tape ht, and then wound up and collected.

Twice separation may realize separation and removal of the piece ta of the double-faced adhesive tape in a poor-joining condition together with the separator s. Then, the transportation robot 43 transports the wafer W having an exposed surface from the separation table 50. That is, the wafer W is again transported and placed on the joining table 19. Thereafter, joining operation of the double-faced adhesive tape is to be repeated as above.

Thus, a round of operation is completed as mentioned above. The similar operation is to be repeated hereinafter.

The foregoing exemplary apparatus may overcome a problem possibly occurring in a pre-cut double-faced adhesive tape having a larger thickness than an adhesive tape of two layers consisting of a base material and an adhesive layer. Specifically, the original master roll TR having the double-faced adhesive tape t wound in a roll form is set into the double-faced adhesive tape joining apparatus. Then, the double-faced adhesive tape t is half-cut into the wafer shape W with the Thomson blade 11 on the carrier tape ct of the original master tape T by guiding the original tape T to the knife edge 14, and is transported into a joining position.

Consequently, a problem may be overcome that occurs in the double-faced adhesive tape pre-cut in advance in the wafer shape. Specifically, there may be overcome deviation in winding and rolling of the double-faced adhesive tape in a roll form, which leads to serpentine thereof during a transportation process, and deviation in joining position of the double-faced adhesive tape to the wafer. In other words, the piece ta of the double-faced adhesive tape may be joined to the wafer W with high accuracy.

Moreover, no impression of the edge of one piece of the double-faced adhesive tape may be formed on the surface of another piece of the double-faced adhesive tape. Consequently, in the foregoing exemplary apparatus, even when back grinding is performed to the rear face of the wafer W while the wafer W is joined to the support substrate via the piece ta of the double-faced adhesive tape, no variation in thickness of the wafer may be generated.

This invention may be embodied as the following aspects.

(1) In the foregoing embodiments, even when the piece ta of the double-faced adhesive tape is accurately joined to the wafer W, the separator s may be separated and removed to be housed into the cassette C for immediately moving to a support substrate joining process. Alternatively, the wafer W may be collected without separating the separator s, and the separator s may be separated from the piece ta of the double-faced adhesive tape during the support substrate joining process.

(2) The foregoing embodiments may adopt an aspect in which the wafer W under poor joining condition is immediately collected into a cassette for defective items without separation.

(3) Substrates to be processed to which the double-faced adhesive tape t is to be joined include not only a semiconductor wafer in a circular shape but various substrates such as a rectangular glass substrate.

(4) In the foregoing exemplary apparatus, the blade holder 7 in the tape pre-cut mechanism 2 has an attachable Thomson blade with a shape following the contour of the substrate to be joined to the double-faced adhesive tape. Alternatively, two or more blade holders 7 each having a Thomson blade in a different shape may be replaced appropriately.

It will be apparent to those skilled in the art that various modifications and variations can be made in the present invention without departing from the spirit or scope of the invention. Thus, it is intended that the present invention cover the modifications and variations of this invention provided they come within the scope of the appended claims and their equivalents.

## Claims

1. A method of joining a double-faced adhesive tape to a substrate, comprising the steps of:
feeding out an original master tape from an original master roll, the original master tape having a long carrier tape and the long double-faced adhesive tape joined thereto;
half-cutting the double-faced adhesive tape in advance on the carrier tape with a cutting member having a corresponding shape to the substrate without completely cutting the carrier tape;
separating the double-faced adhesive tape cut out into a substrate shape from the carrier tape; and
joining the double-faced adhesive tape to the substrate through traveling and folding back the carrier tape having the piece of the double-faced adhesive tape in the substrate shape applied thereto with a knife edge to separate a piece of the double-faced adhesive tape in the substrate shape from the carrier tape, and joining a separated piece of the double-faced adhesive tape to the substrate relatively moving at a speed synchronized to a separation speed.

2. The method of joining the double-faced adhesive tape according to claim 1,
wherein
the cutting member is a Thomson blade having an annular cutting edge for pressing against the double-faced adhesive tape on the carrier tape to cut the double-faced adhesive tape into the substrate shape.

3. Double-faced adhesive tape joining apparatus for joining a double-faced adhesive tape to a substrate, comprising:
a tape supply unit for supplying, from an original master roll, an original master tape having the long double-faced adhesive tape laminated to a long carrier tape joined thereto;
a tape traveling guidance mechanism for traveling the original master tape fed out from the tape supply unit along a given tape transportation path and guiding the original master tape to a knife edge;
a tape pre-cut mechanism for half-cutting the double-faced adhesive tape to the carrier tape into a substrate shape on the tape transportation path in front of the knife edge to form a piece of the double-faced adhesive tape;
a tape separation mechanism for separating the double-faced adhesive tape cut out into the substrate shape from the carrier tape;
a joining table for holding the substrate;
a table driving mechanism for relatively moving the joining table relative to the knife edge at a speed synchronized to a tape traveling speed;
a tape joining mechanism provided with a joining roller for pressing against the substrate on the joining table the piece of the double-faced adhesive tape into the substrate shape that is separated from the carrier tape through folding back and traveling the original master tape with the knife edge; and
a carrier tape collecting section for collecting the carrier tape from which the piece of the double-faced adhesive tape is separated.

4. The double-faced adhesive tape joining apparatus according to claim 3,
wherein
the cutting member is a Thomson blade having an annular cutting edge for pressing against the double-faced adhesive tape on the carrier tape to cut the double-faced adhesive tape into the substrate shape.

5. The double-faced adhesive tape joining apparatus according to claim 4,
wherein
the tape pre-cut mechanism includes blade holder that allow replacement of a Thomson blade in accordance with the substrate shape.
